# EUROPEAN PATENT APPLICATION

(11) **EP 4 835 955 A1**
(43) Date of publication of application: **04.11.2026**
(21) Application number: 24912046.0
(22) Date of filing: 08.11.2024
(51) Int. Cl.: H01L 21/304, H01L 21/027

(54) **SUBSTRATE PROCESSING APPARATUS AND SUBSTRATE PROCESSING METHOD**

(30) Priority: 28.12.2023 JP 2023223631
(71) Applicant: SCREEN Holdings Co., Ltd., Kyoto-shi, Kyoto 602-8585 (JP)
(72) Inventor: HIGUCHI, Tomomi, Kyoto-shi, Kyoto 602-8585 (JP)
(74) Representative: Kilian Kilian & Partner mbB
(86) International application number: PCT/JP2024/039876
(87) International publication number: WO 2025/142153

(57) **Abstract**

A substrate processing apparatus includes a nozzle that discharges a processing liquid, a first liquid supply system that includes a first pipe connected to the nozzle, and supplies a first liquid to the nozzle through the first pipe, a second liquid supply system that includes a plurality of second sub-pipes respectively connected to a plurality of different portions of a liquid flow path formed by the nozzle and the first pipe, and supplies a second liquid to the liquid flow path through any one of the second sub-pipes, and a controller that controls the first liquid supply system and the second liquid supply system based on a plurality of work conditions during a removal process of removing a film formed on a substrate. The plurality of work conditions are respectively associated with the plurality of portions of the substrate.

## Description

### [Technical Field]

The present invention relates to a substrate processing apparatus that removes an unnecessary film formed on one surface of a substrate, and a substrate processing method of removing the unnecessary film formed on the one surface of the substrate.

### [Background Art]

A substrate processing apparatus is used to execute various processes on a substrate such as a semiconductor substrate, a substrate for a flat panel display (FPD) that is used for a liquid crystal display device, an organic electroluminescence (EL) display device, or the like, a substrate for an optical disc, a substrate for a magnetic disc, a substrate for a magneto-optical disc, a substrate for a photomask, a ceramic substrate or a substrate for a solar cell.

In a substrate processing apparatus described in Patent Document 1, an unnecessary resist film formed on one surface of a substrate (wafer) is removed using a sulfuric acid hydrogen peroxide mixture (SPM). More specifically, the substrate having the resist film is held in a horizontal posture by a spin chuck, and rotated about a vertical axis. In this state, an SPM nozzle is disposed at a position above the rotating substrate, and the SPM is supplied from the SPM nozzle toward the rotation center of the substrate. The SPM is a mixed liquid of sulfuric acid (H₂SO₄) and a hydrogen peroxide solution (H₂O₂), and has a strong oxidizing power. Thus, the resist film on the substrate is stripped off and removed from the one surface of the substrate by the oxidizing power of the SPM.

[Patent Document 1] JP 2008-4819 A

### [Summary of Invention]

### [Technical Problem]

Meanwhile, in a case in which the SPM is supplied onto the substrate having the resist film, a plurality of portions of the resist film are not necessarily uniformly removed. For example, the resist film formed on the substrate may include a portion that is likely to be removed from one surface of the substrate and a portion that is unlikely to be removed from the one surface of the substrate due to factors such as variations in thickness of the resist film and variations in adhesion between the substrate and the resist film. As such, in order to reliably remove the portion of the resist film that is unlikely to be removed from the one surface of the substrate, it is conceivable to increase a period of time during which the SPM is supplied to the substrate.

However, when the SPM is supplied to the portion of the resist film that is likely to be removed from the one surface of the substrate for a long period of time, the SPM is supplied to the exposed portion of the substrate for a long period of time after the resist film is removed. In this case, part of the substrate may be damaged by the oxidizing power of the SPM. Further, the supply of the SPM for a long period of time increases an amount of the SPM to be used for one substrate.

An object of the present invention is to provide a substrate processing apparatus and a substrate processing method that enable removal of an unnecessary film formed on one surface of a substrate without damaging the substrate, and reduce an amount of a processing liquid to be used.

### [Solution to Problem]

A substrate processing apparatus according to one aspect of the present invention executes a removal process of removing, using a processing liquid including Caro's acid, an unnecessary film formed on one surface of a substrate, wherein in a case in which one of sulfuric acid and a hydrogen peroxide solution is a first liquid, and another one of the sulfuric acid and the hydrogen peroxide solution is a second liquid, the Caro's acid is generated by mixing the first liquid and the second liquid, the substrate processing apparatus includes a nozzle that discharges the processing liquid such that the processing liquid impinges on a plurality of portions on the one surface of the substrate, a first liquid supply system that includes a first pipe connected to the nozzle, and supplies the first liquid to the nozzle through the first pipe, a second liquid supply system that includes a plurality of second pipes respectively connected to a plurality of different portions of a liquid flow path formed by the nozzle and the first pipe, and supplies the second liquid to the liquid flow path through any one of the plurality of second pipes, and a controller that controls the first liquid supply system and the second liquid supply system based on a plurality of predetermined work conditions during the removal process, and the plurality of work conditions are respectively associated with the plurality of portions of the substrate such that a processing liquid having a film-removal capability corresponding to each portion of the plurality of portions of the one surface of the substrate impinges on the portion.

A substrate processing method according to yet another aspect of the present invention is executed using a substrate processing apparatus, with the substrate processing apparatus executing a removal process of removing, using a processing liquid including Caro's acid, an unnecessary film formed on one surface of a substrate, wherein in a case in which one of sulfuric acid and a hydrogen peroxide solution is a first liquid, and another one of the sulfuric acid and the hydrogen peroxide solution is a second liquid, the Caro's acid is generated by mixing the first liquid and the second liquid, the substrate processing apparatus includes a nozzle that discharges the processing liquid such that the processing liquid impinges on a plurality of portions on the one surface of the substrate, a first liquid supply system that includes a first pipe connected to the nozzle, and supplies the first liquid to the nozzle through the first pipe, and a second liquid supply system that includes a plurality of second pipes respectively connected to a plurality of different portions of a liquid flow path formed by the nozzle and the first pipe, and supplies the second liquid into the first pipe through any one of the plurality of second pipes, and the substrate processing method includes the steps of, in regard to each portion of the plurality of portions of the one surface of the substrate, acquiring information relating to a film-removal capability of the processing liquid to be supplied to the portion, based on the acquired information, setting work conditions of the first liquid supply system and the second liquid supply system corresponding to each of the plurality of portions of the substrate such that processing liquids having respectively corresponding film-removal capabilities impinge on the plurality of portions of the one surface of the substrate, and controlling the first liquid supply system and the second liquid supply system based on the set work conditions of the first liquid supply system and the second liquid supply system.

### [Advantageous Effects of Invention]

With the present invention, it is possible to remove an unnecessary film formed on one surface of a substrate without damaging the substrate, and reduce an amount of a processing liquid to be used.

### [Brief Description of the Drawings]

[FIG. 1] Fig. 1 is a schematic diagram showing the configuration of a substrate processing apparatus according to one embodiment of the present invention.
[FIG. 2] Fig. 2 is a plan view of the substrate processing apparatus for explaining the functions of a nozzle supporter and a nozzle moving device of Fig. 1.
[FIG. 3] Fig. 3 is a block diagram showing the configuration of a control system of the substrate processing apparatus of Fig. 1.
[FIG. 4] Fig. 4 is a diagram showing one example of a temporal change of a removal state of a resist film during a removal process.
[FIG. 5] Fig. 5 is a diagram showing another example of a temporal change of a removal state of a resist film during the removal process.
[FIG. 6] Fig. 6 is a diagram showing a first specific example of a plurality of work conditions set to respectively correspond to a plurality of portions of the substrate W.
[FIG. 7] Fig. 7 is a diagram showing a second specific example of a plurality of work conditions set to respectively correspond to a plurality of portions of the substrate W.
[FIG. 8] Fig. 8 is a flowchart showing one example of a film removal process executed by a controller of Fig. 1.
[FIG. 9] Fig. 9 is a schematic diagram showing the configuration of a substrate processing apparatus according to another embodiment.
[FIG. 10] Fig. 10 is a diagram showing one example of three processing liquid supply devices according to another embodiment.

### [Description of Embodiments]

A substrate processing apparatus and a substrate processing method according to one embodiment of the present invention will be described below with reference to the drawings. In the following description, a substrate refers to a substrate for a flat panel display (FPD) that is used for a liquid crystal display device, an organic electroluminescence (EL) display device, or the like, a semiconductor substrate, a substrate for an optical disc, a substrate for a magnetic disc, a substrate for a magneto-optical disc, a substrate for a photomask, a ceramic substrate, a substrate for a solar cell, or the like.

Further, the substrate processing apparatus, described below, is a single-wafer substrate processing apparatus used for a removal process of removing an unnecessary film (a resist film in the present example) formed on one surface (main surface) of the substrate. In the removal process according to the present embodiment, the substrate having the unnecessary film formed on the one surface thereof is rotated in a horizontal posture. A sulfuric acid hydrogen peroxide mixture (SPM) is supplied as a processing liquid to the one surface of the substrate. The SPM is a mixed liquid of sulfuric acid (H₂SO₄) and a hydrogen peroxide solution (H₂O₂), and includes Caro's acid (H₂SO₅). Caro's acid is generated by the chemical reaction between sulfuric acid and a hydrogen peroxide solution, has a strong oxidizing power, and dissolves the unnecessary film by reacting with the film. This causes the unnecessary film to be stripped from the one surface of the substrate and removed.

### <1> Configuration of Substrate Processing Apparatus

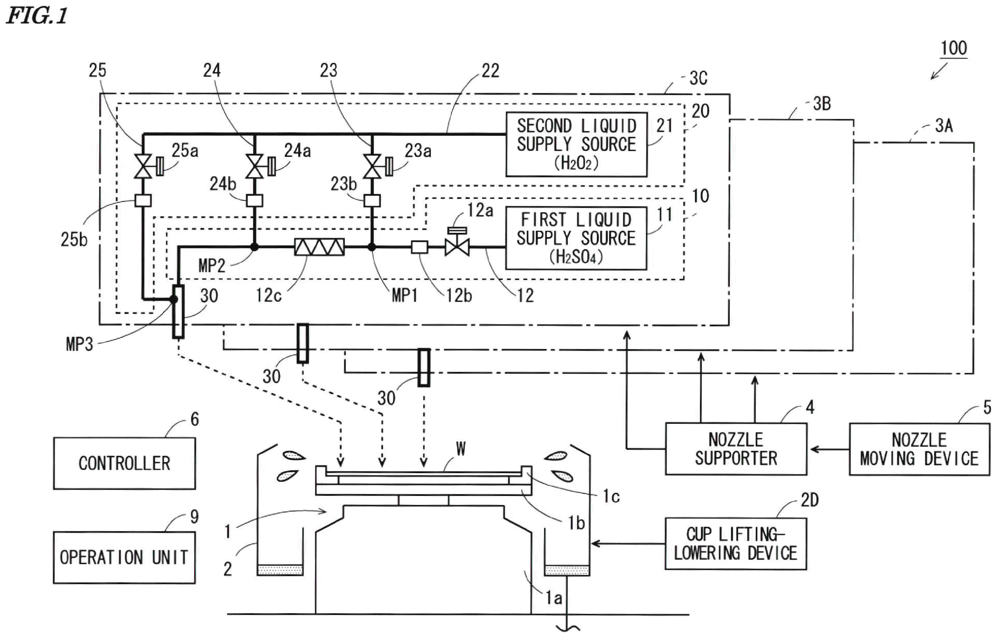

Fig. 1 is a schematic diagram showing the configuration of the substrate processing apparatus according to the one embodiment of the present invention. As shown in Fig. 1, the substrate processing apparatus 100 mainly includes a spin chuck 1, a cup 2, a cup lifting-lowering device 2D, three processing liquid supply devices 3A, 3B, 3C, a nozzle supporter 4, a nozzle moving device 5, a controller 6, and an operation unit 9.

At least part of the substrate processing apparatus 100 is provided in a chamber (not shown). The spin chuck 1 has a spin motor 1a, a spin base 1b, and chuck pins 1c. The spin motor 1a is provided in a bottom portion of the chamber such that a rotation shaft projects upwardly. The spin base 1b has a disc shape, and is attached to an upper end portion of the rotation shaft of the spin motor 1a in a horizontal posture. The plurality of chuck pins 1c are provided on an upper surface of the spin base 1b, and hold a peripheral portion of the substrate W. The spin motor 1a works with the plurality of chuck pins 1c holding the substrate W. This causes the substrate W to rotate about a vertical axis.

As described above, in the present example, the mechanical spin chuck 1 that holds the peripheral portion of the substrate W is used. Instead of the mechanical spin chuck, a suction-type spin chuck that holds a lower surface of the substrate W by suction may be used.

The cup 2 is provided so as to surround the spin chuck 1. The cup 2 is supported by the cup lifting-lowering device 2D such that the cup 2 can be lifted and lowered. The cup lifting-lowering device 2D includes an air cylinder, or the like, and moves the cup 2 between two predetermined height positions (an upper position and a lower position, described below).

The three processing liquid supply devices 3A, 3B, 3C basically have the same configuration. In Fig. 1, details of only the processing liquid supply device 3C is shown. The configuration of the processing liquid supply device 3C will be described as a representative of the three processing liquid supply devices 3B, 3C, 3C.

The processing liquid supply device 3C mainly includes a first liquid supply system 10, a second liquid supply system 20, and a nozzle 30. The first liquid supply system 10 includes a first liquid supply source 11, a first pipe 12, a valve 12a, an adjuster 12b, and a stirrer 12c. The first liquid supply source 11 is a supply source of sulfuric acid, and includes a utility facility of a factory, a liquid sending device including a liquid storage, or the like. An upstream end of the first pipe 12 is connected to the first liquid supply source 11. A downstream end of the first pipe 12 is connected to the nozzle 30. The valve 12a, the adjuster 12b, and the stirrer 12c are provided in the first liquid supply source 11 so as to be arranged in this order from the upstream end to the downstream end of the first liquid supply source 11.

The valve 12a is a ball valve, for example, allows a liquid flow in the first pipe 12 when the valve 12a is in an open state, and blocks a liquid flow in the first pipe 12 when the valve 12a is in a close state. The adjuster 12b includes a flow-rate adjuster such as a motor needle valve or a regulator, and adjusts a flow rate of a liquid flowing through the first pipe 12. In the present example, the adjuster 12b is a motor needle valve. The stirrer 12c is an in-line mixer, for example, and mixes a plurality of types of liquids (sulfuric acid and a hydrogen peroxide solution in the present example) flowing through the first pipe 12 by generating a vortex flow or the like in the first pipe 12.

In the present embodiment, in a liquid flow path formed by the first pipe 12 and the nozzle 30, a portion located between the adjuster 12b and the stirrer 12c is referred to as a first portion MP1. Further, a portion located between the stirrer 12c and the nozzle 30 is referred to as a second portion MP2, and a portion located at the nozzle 30 is referred to as a third portion MP3.

The second liquid supply system 20 includes a second liquid supply source 21, a second main pipe 22, a plurality (three in the present example) of second sub-pipes 23, 24, 25, a plurality (three in the present example) of valves 23a, 24a, 25a, and a plurality (three in the present example) of adjusters 23b, 24b, 25b. The second liquid supply source 21 is a supply source of the hydrogen peroxide solution, and similarly to the example of the first liquid supply source 11, includes a utility facility of a factory, a liquid sending device including a liquid storage, or the like.

An upstream end of the second main pipe 22 is connected to the second liquid supply source 21. The second main pipe 22 has a plurality (two in the present example) of branch portions arranged from an upstream position toward a downstream position. Upstream ends of the second sub-pipes 23, 24, 25 are respectively connected to an upstream branch portion of the second main pipe 22, a downstream branch portion of the second main pipe 22, and a downstream end of the second main pipe 22. On the other hand, downstream ends of the second sub-pipes 23, 24, 25 are respectively connected to the first portion MP1, the second portion MP2, and the third portion MP3 of the above-mentioned liquid flow path.

In the second sub-pipe 23, the valve 23a and the adjuster 23b are provided in this order from an upstream position toward a downstream position. In the second sub-pipe 24, the valve 24a and the adjuster 24b are arranged in this order from an upstream position toward a downstream position. In the second sub-pipe 25, the valve 25a and the adjuster 25b are arranged in this order from an upstream position toward a downstream position.

The valves 23a, 24a, 25a have the same configuration as that of the valve 12a. Further, the adjusters 23b, 24b, 25b have the same configuration as that of the adjuster 12b. At least one of the valves 12a, 23a, 24a, 25a may have a configuration different from those of the other valves. Some of the adjusters 12b, 23b, 24b, 25b may also have a configuration different from those of the other adjusters.

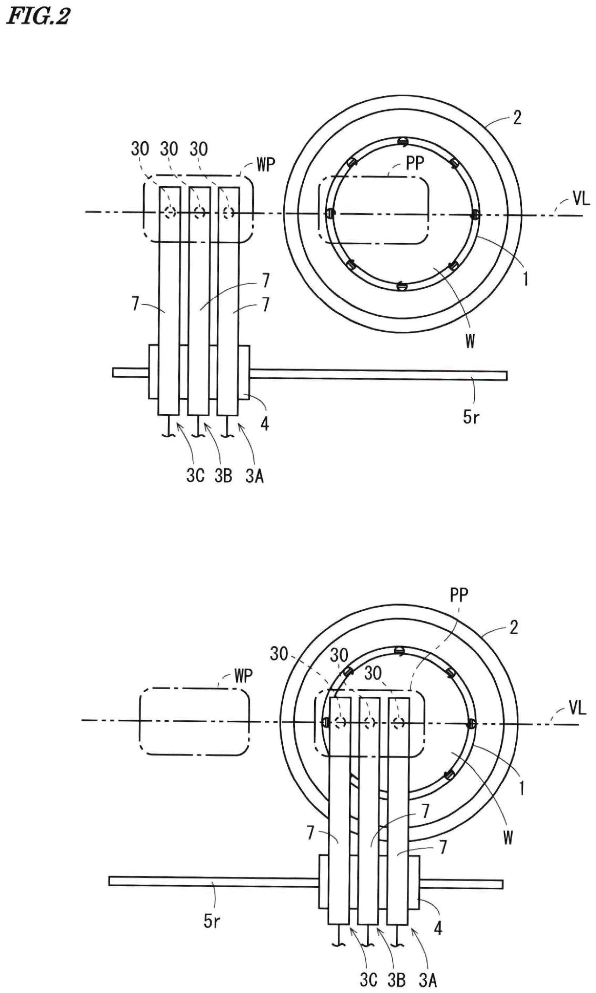

In each of the above-mentioned processing liquid supply devices 3A, 3B, 3C, the configuration of the first liquid supply system 10 and the configuration of the second liquid supply system 20 are partially supported by an arm member 7 (Fig. 2) made of a hard resin, for example.

Fig. 2 is a plan view of the substrate processing apparatus 100 for explaining functions of the nozzle supporter 4 and the nozzle moving device 5 of Fig. 1. As shown in the upper field of Fig. 2, a rail 5r is provided at a bottom portion of the chamber and sideward of the spin chuck 1 and the cup 2 in plan view. The rail 5r is provided so as to extend in one direction at a position close to the spin chuck 1 and the cup 2. In the following description, the direction in which the rail 5r extends in plan view is referred to as a rail direction. Further, in plan view, a straight line passing through the center of the substrate W held by the spin chuck 1 and extending in the rail direction is referred to as a virtual line VL.

The arm member 7 corresponding to each of the three processing liquid supply device 3A, 3B, 3C has a rod shape, for example, and supports the nozzle 30 using its tip end portion. The nozzle supporter 4 supports the three arm members 7 such that the three nozzles 30 are arranged on the virtual line VL, and are provided on the rail 5r so as to be movable in the rail direction. A motor forming part of the nozzle moving device 5 is attached to the nozzle supporter 4. This causes the nozzle supporter 4 to move on the rail 5r when the nozzle moving device 5 works.

In the substrate processing apparatus 100, in plan view, a waiting position WP is set at a position on the virtual line VL deviated from the spin chuck 1 and the cup 2. Further, in plan view, a processing position PP is set at a position overlapping with the spin chuck 1 on the virtual line VL. In a case in which the substrate processing apparatus 100 is in a waiting state where not executing the removal process, the three nozzles 30 of the three processing liquid supply devices 3A, 3B, 3C are held at the waiting position WP in plan view as shown in the upper field of Fig. 2. On the other hand, in a case in which the substrate processing apparatus 100 executes the removal process, the three nozzles 30 of the processing liquid supply devices 3A, 3B, 3C are held at the processing position PP in plan view as shown in the lower field of Fig. 2.

In the present embodiment, with the three nozzles 30 held at the processing position PP during the removal process, the three nozzle 30 are positioned at predetermined position with respect to the substrate W held by the spin chuck 1.

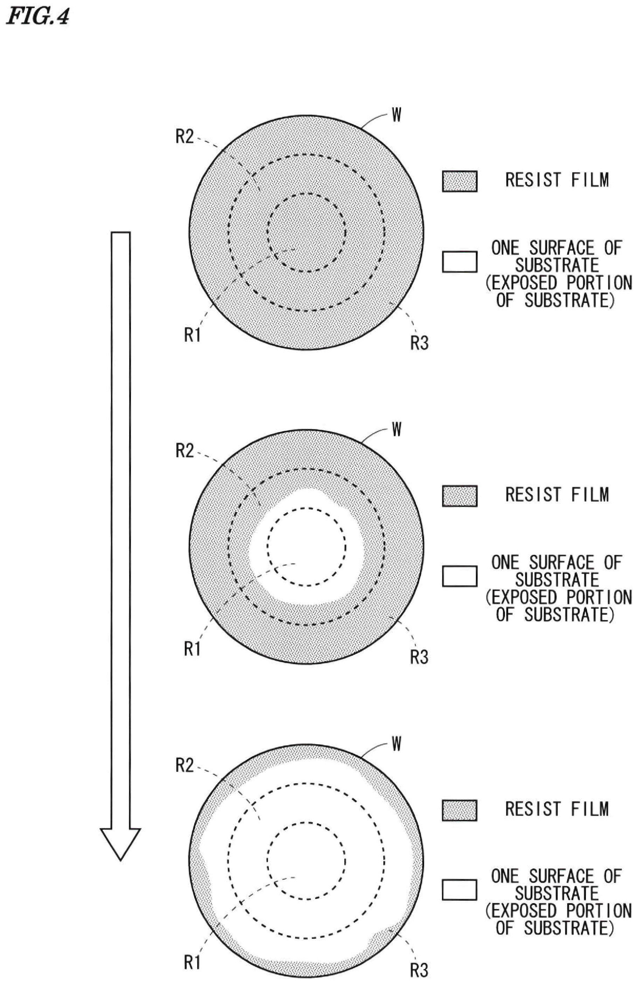

Specifically, the nozzle 30 of the processing liquid supply device 3A is positioned so as to overlap with a center portion (an inner portion R1 (Fig. 4 and the like), described below) of the substrate W in plan view. Further, the nozzle 30 of the processing liquid supply device 3B is positioned so as to overlap with an intermediate portion (a middle portion R2 (Fig. 4 and the like), described below) between the center of the substrate W and the outer peripheral end of the substrate W in plan view. Further, the nozzle 30 of the processing liquid supply device 3C is positioned so as to overlap with a peripheral portion (an outer portion R3 (Fig. 4 and the like), described below) of the substrate W in plan view. While being positioned in this manner, each nozzle 30 is supported such that a discharge port of the nozzle 30 is opposite to one surface of the substrate W. Thus, during the removal process, the processing liquid is discharged from the discharge port of each nozzle 30 toward three portions on the one surface of the substrate W. The discharged processing liquid impinges on the one surface of the substrate W (more precisely, the one surface of the substrate W or the resist film covering the one surface of the substrate W).

The substrate processing apparatus 100 according to the present embodiment includes a rinse nozzle (not shown), and a rinse liquid supply system (not shown) that supplies a rinse liquid to the rinse nozzle. After the resist film is removed by the processing liquid, the rinse nozzle discharges the rinse liquid toward the one surface of the substrate W on which the processing liquid remains. This removes the processing liquid on the substrate W (a rinsing process). Details of the controller 6 and the operation unit 9 will be described below.

### <2> Control System of Substrate Processing Apparatus

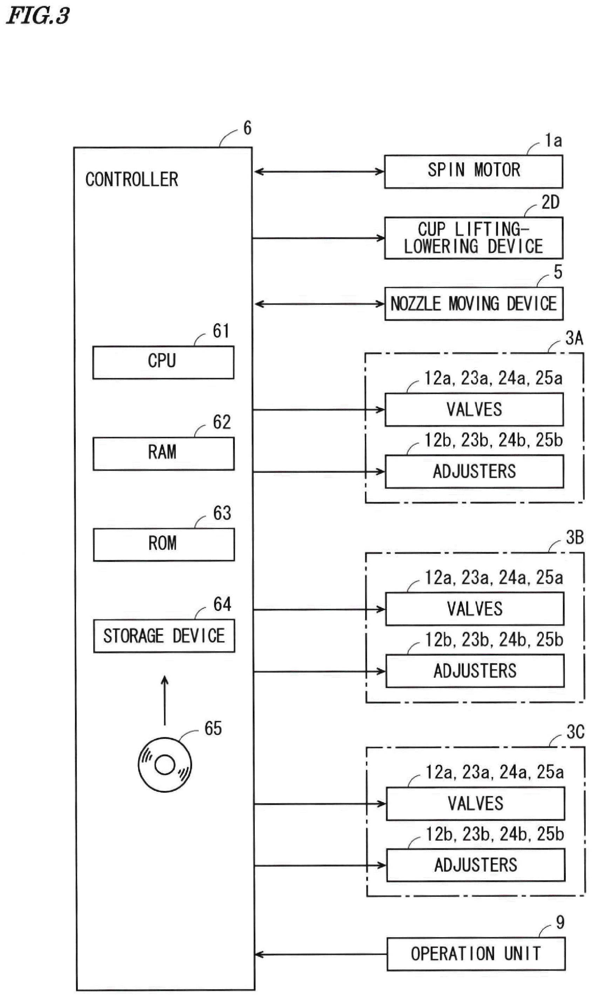

A control system of the substrate processing apparatus 100 will be described together with configurations of the controller 6 and the operation unit 9 of Fig. 1. Fig. 3 is a block diagram showing the configuration of the control system of the substrate processing apparatus 100 of Fig. 1. As shown in Fig. 3, the controller 6 includes a central processing unit (CPU) 61, a random access memory (RAM) 62, a read only memory (ROM) 63, and a storage device 64.

The RAM 62 is used as a work area for the CPU 61. A system program is stored in the ROM 63. The storage device 64 includes a storage medium such as a hard disc or a semiconductor memory, and stores a film removal program for executing the removal process. Further, the storage device 64 stores a plurality of work conditions of the substrate processing apparatus 100 relating to the removal process. The plurality of work conditions are respectively associated with a plurality of portions of the substrate W to be subjected to the removal process. Details of the plurality of work conditions will be described below.

The film removal program may be provided in the state of being stored in a recording medium such as a CD-ROM 65, and installed in the ROM 63 or the storage device 64. Alternatively, the film removal program may be distributed from a server outside of the substrate processing apparatus 100 via a communication network, and installed in the ROM 63 or the storage device 64.

The CPU 61 executes the film removal program, thereby controlling the work of each component of the substrate processing apparatus 100 during the removal process. Specifically, with the substrate W placed on the spin base 1b and held by the plurality of chuck pins 1c, the controller 6 rotates the substrate W by controlling the spin motor 1a.

The controller 6 also controls the cup lifting-lowering device 2D such that the cup 2 is held at the lower position when the substrate W is placed on the spin chuck 1, when the substrate W is taken out from the spin chuck 1, and when the removal process is not executed. Here, the lower position refers to a position of the cup 2 when an upper end portion of the cup 2 is located below the substrate W held by the spin chuck 1.

Further, during the removal process, the controller 6 controls the cup lifting-lowering device 2D such that the cup 2 is held at the upper position. Here, the upper position refers to a position of the cup 2 when the upper end portion of the cup 2 is above the substrate W held by the spin chuck 1 and an inner peripheral surface of the cup 2 faces the outer peripheral end of the substrate W in a horizontal plane. In this case, the processing liquid splashing from the substrate W during the removal process is received by the inner peripheral surface of the cup 2. The processing liquid received by the cup 2 is discarded through a drain pipe.

Further, during the removal process, the controller 6 controls the nozzle moving device 5 such that the three nozzles 30 of the three processing liquid supply devices 3A, 3B, 3C are held at the processing position PP. Further, in a period during which the removal process is not executed, the controller 6 controls the nozzle moving device 5 such that the three nozzles 30 of the three processing liquid supply devices 3A, 3B, 3C are held at the waiting position WP.

As described above, the plurality of work conditions of the substrate processing apparatus 100 relating to the removal process are stored in the storage device 64 of the controller 6. The plurality of work conditions include information relating to the work of each of the plurality of valves 12a, 23a, 24a, 25a and the plurality of adjusters 12b, 23b, 24b, 25b of the three processing liquid supply devices 3A, 3B, 3C.

During the removal process, the controller 6 controls the plurality of valves 12a, 23a, 24a, 25a and the plurality of adjusters 12b, 23b, 24b, 25b of the three processing liquid supply devices 3A, 3B, 3C based on the plurality of work conditions. In this case, in each of the processing liquid supply devices 3A, 3B, 3C, with the sulfuric acid flowing through the first pipe 12, the hydrogen peroxide solution is supplied from the second liquid supply system 20 to at least two of the first portion MP1, the second portion MP2, and the third portion MP3 of the liquid flow path. This causes the sulfuric acid and the hydrogen peroxide solution to be mixed multiple times in the liquid flow path, and the processing liquid (SPM) is generated.

The operation unit 9 of Fig. 1 includes a keyboard and a pointing device, and is configured to be operable by a user. The user can input the plurality of above-mentioned work conditions by operating the operation unit 9. When the plurality of work conditions are input using the operation unit 9, the controller 6 stores the input work conditions in the storage device 64.

### <3> Film Removability and Film-Removal Capability of Processing Liquid

In the following description, a degree of how likely the resist film is removed during the removal process is referred to as removability. "High removability" means that the resist film is likely to be removed, and "low removability" means that the resist film is unlikely to be removed.

The removability of the one substrate W may differ in a plurality of portions on the one surface of the substrate W depending on a material forming the resist film formed on the one substrate W, a thickness distribution of the resist film, a distribution of adhesion between the resist film and the substrate W, and the like. The distribution of removability on the one surface of the one substrate W can be identified to some extent by executing the removal process on a sample substrate of the same type as that of the one substrate W in advance or by executing a simulation of the removal process.

Further, in the following description, capability of the processing liquid to remove the resist film is referred to as a film-removal capability. A degree of film-removal capability represents a degree of reactivity of the processing liquid with respect to the resist film formed on the substrate W, and is mainly determined by a concentration of Caro's acid in the processing liquid.

Fig. 4 is a diagram showing one example of a temporal change of a removal state of the resist film during the removal process. In Fig. 4, plan views showing the states of the resist film when the processing liquid having the common film-removal capability is supplied to the entire one surface of the substrate W are shown in chronological order in the order of the plan view in the upper field, the plan view in the middle field, and the plan view in the lower field. In each of the plan views in the upper, middle, and lower fields of Fig. 4, the resist film present on the substrate W is indicated by the dotted pattern.

The temporal change of the removal state of the resist film as shown in Fig. 4 can be acquired by capturing an image of the state of the one surface of the substrate W during the removal process using a camera every time a predetermined period of time elapses.

Here, in the one surface of the substrate W, the inner portion R1, the middle portion R2, and the outer portion R3 are defined. The inner portion R1 is located at the center of the substrate W. The middle portion R2 has an annular shape, and surrounds the inner portion R1. The outer portion R3 has an annular shape including the outer peripheral end of the substrate W, and surrounds the middle portion R2. The radius of the inner portion R1, the width of the middle portion R2 in a radial direction of the substrate W, and the width of the outer portion R3 in the radial direction of the substrate W are equal to one another.

In the example of Fig. 4, after the removal process is started, the resist film is sequentially removed from the center portion of the substrate W toward the outer peripheral end of the substrate W. Therefore, it is found that, in the substrate W corresponding to the example of Fig. 4, the inner portion R1 has high removability, the middle portion R2 has medium removability, and the outer portion R3 has ow removability.

Thus, it is found that it is preferable to supply the processing liquid having a low film-removal capability to the inner portion R1 of the substrate W corresponding to the example of Fig. 4. In this case, by supplying the processing liquid having a low film-removal capability to the inner portion R1, it is possible to suppress damage to the inner portion R1 in the one surface of the substrate W during the removal process.

Further, it is found that it is preferable to supply the processing liquid having a high film-removal capability to the outer portion R3 of the substrate W corresponding to the example of Fig. 4. In this case, by supplying the processing liquid having a high film-removal capability to the outer portion R3, it is possible to efficiently remove the resist film from the outer portion R3 during the removal process. That is, a processing period of time required for removing the resist film from the outer portion R3 can be reduced.

Furthermore, it is found that it is preferable to supply the processing liquid having a medium film-removal capability to the middle portion R2 of the substrate W corresponding to the example of Fig. 4.

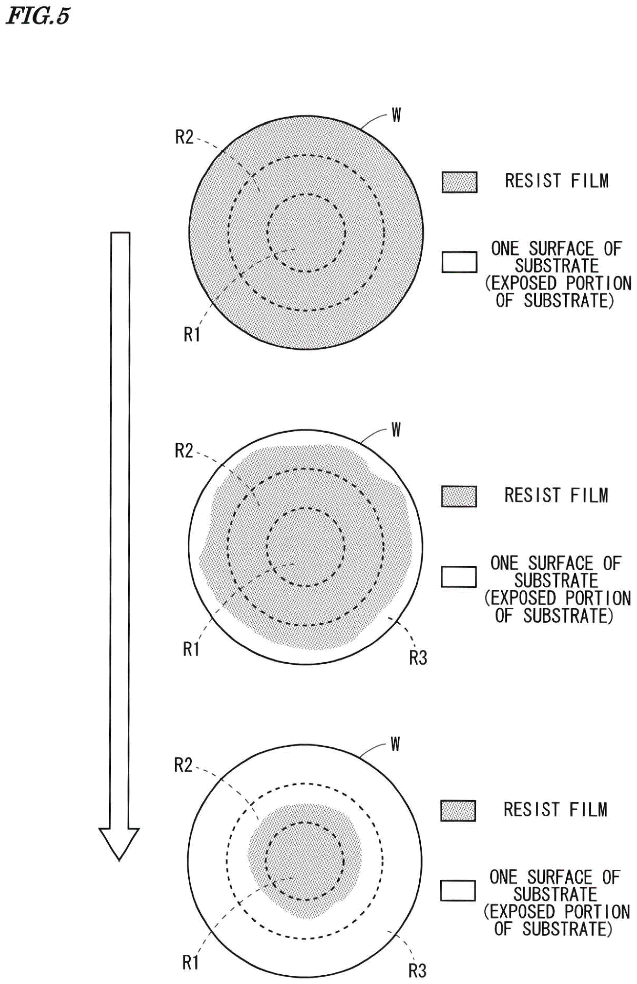

Fig. 5 is a diagram showing another example of a temporal change of a removal state of the resist film during the removal process. In Fig. 5, similarly to the example of Fig. 4, plan views showing the states of the resist film when the processing liquid having a common film-removal capability is supplied to the entire one surface of the substrate W are shown in chronological order in the order of the plan view in the upper field, the plan view in the middle field, and the plan view in the lower field. In each of the plan views in the upper, middle, and lower fields of Fig. 5, the resist film present on the substrate W is indicated by the dotted pattern.

In the example of Fig. 5, after the removal process is started, the resist film is sequentially removed from the outer peripheral end of the substrate W toward the center portion of the substrate W. Therefore, it is found that, in the substrate W corresponding to the example of Fig. 5, the inner portion R1 has low removability, the middle portion R2 has medium removability, and the outer portion R3 has high removability.

Thus, it is found that it is preferable to supply the processing liquid having a high film-removal capability to the inner portion R1 of the substrate W corresponding to the example of Fig. 5. Further, it is found that it is preferable to supply the processing liquid having a low film-removal capability to the outer portion R3 of the substrate W corresponding to the example of Fig. 5. Furthermore, it is found that it is preferable to supply the processing liquid having a medium film-removal capability to the middle portion R2.

The distributions of removability of the resist film on the substrate W as shown in Figs. 4 and 5 can be identified to some extent by executing the removal process on a sample substrate W in advance or by executing a simulation. Further, according to the identified distributions of removability, the film-removal capability of the processing liquid to be supplied to each of the plurality of portions of the substrate W can be predicted as described above.

In the present embodiment, according to the removability of the resist film on the one surface of the substrate W to be processed, the film-removal capability of the processing liquid to be supplied to each of the plurality of portions of the substrate W is predicted. Based on that prediction, information representing the relationship between each of the plurality of portions of the substrate W and the preferable film-removal capability corresponding to the portion is acquired as substrate portion information.

In the substrate processing apparatus 100 of Fig. 1, the three processing liquid supply devices 3A, 3B, 3C are provided to respectively correspond to the inner portion R1, the middle portion R2, and the outer portion R3 of the substrate W. The film-removal capability of the processing liquid discharged from the nozzle 30 of each of the processing liquid supply devices 3A, 3B, 3C can be adjusted by controlling the work of each component of the first liquid supply system 10 and the second liquid supply system 20 of the processing liquid supply device.

As such, in the present embodiment, the work conditions of the first liquid supply system 10 and the second liquid supply system 20 of the processing liquid supply device 3A corresponding to the inner portion R1 of the substrate W are determined based on the acquired substrate portion information. Further, the work conditions of the first liquid supply system 10 and the second liquid supply system 20 of the processing liquid supply device 3B corresponding to the middle portion R2 of the substrate W are determined based on the substrate portion information. Further, the work conditions of the first liquid supply system 10 and the second liquid supply system 20 of the processing liquid supply device 3C corresponding to the outer portion R3 of the substrate W are determined based on the substrate portion information. Further, the plurality of work conditions respectively corresponding to the plurality of portions (the inner portion R1, the middle portion R2, and the outer portion R3 in the present example) of the substrate W are input by a user operation of the operation unit 9, and are stored in the storage device 64 of Fig. 3.

### <4> Relationship Between Film-Removal Capability of Processing Liquid and Work Conditions of Processing Liquid Supply Device

As described above, the degree of film-removal capability represents a degree of reactivity of the processing liquid with respect to the resist film formed on the substrate W, and is mainly determined by a concentration of Caro's acid in the processing liquid. In each of the three processing liquid supply devices 3A, 3B, 3C of Fig. 1, the film-removal capability of the processing liquid discharged from the nozzle 30 can be adjusted by controlling the plurality of valves 12a, 23a, 24a, 25a and the plurality of adjusters 12b, 23b, 24b, 25b.

Here, a generation mechanism of Caro's acid in the processing liquid in each of the processing liquid supply devices 3A, 3B, 3C will be described with reference to Fig. 1. In order to discharge the processing liquid from the nozzle 30, the valve 12a is first opened. Further, the adjuster 12b is controlled such that the sulfuric acid flows through the first pipe 12 at a predetermined flow rate. Further, the valve 23a is opened, and the adjuster 23b is controlled such that the hydrogen peroxide solution flows through the second sub-pipe 23 at a predetermined flow rate. In this case, in the first pipe 12, the sulfuric acid and the hydrogen peroxide solution merge in the first portion MP1, and sent to the stirrer 12c. In the stirrer 12c, the sulfuric acid and the hydrogen peroxide solution are stirred. This promotes the chemical reaction between the sulfuric acid and the hydrogen peroxide solution, and thus Caro's acid is generated.

Heat is generated during generation of Caro's acid. This increases a temperature of the processing liquid (mixed liquid) flowing through the stirrer 12c. When the temperature of the processing liquid exceeds a predetermined temperature (about the boiling point of the hydrogen peroxide solution, for example), part of the hydrogen peroxide solution (the hydrogen peroxide solution that does not contribute to the generation of Caro's acid) is likely to be decomposed into water and oxygen. Therefore, an amount of Caro's acid generated in a region of the first pipe 12 from the first portion MP1 to the stirrer 12c is limited.

As such, in each of the above-mentioned processing liquid supply devices 3A, 3B, 3C, a new hydrogen peroxide solution can be respectively supplied to the second portion MP2 and the third portion MP3 downstream of the stirrer 12c of the liquid flow path passing through the first pipe 12.

For example, with Caro's acid being generated in the stirrer 12c, as described above, the valve 24a is opened, and the adjuster 24b is controlled such that the hydrogen peroxide solution flows through the second sub-pipe 24 at a predetermined flow rate. In this case, a new hydrogen peroxide solution that has not been heated to a high temperature is supplied in the second portion MP2, so that new Caro's acid is generated. Thus, the concentration of Caro's acid in the processing liquid flowing through the first pipe 12 downstream of the second portion MP2 increases as compared with the processing liquid flowing through the stirrer 12c.

Alternatively, with Caro's acid being generated in the stirrer 12c, as described above, the valve 25a is opened, and the adjuster 25b is controlled such that the hydrogen peroxide solution flows through the second sub-pipe 25 at a predetermined flow rate. In this case, a new hydrogen peroxide solution that has not been heated to a high temperature is supplied in the third portion MP3, so that new Caro's acid is generated. Thus, the concentration of Caro's acid in the processing liquid discharged from the nozzle 30 increases as compared with the processing liquid flowing through the stirrer 12c.

As a result of various experiments and simulations, the inventor of the present invention confirmed that the concentration of Caro's acid in the processing liquid changed according to the mixing ratio of the sulfuric acid to the hydrogen peroxide solution in each of the plurality of portions (MP1, MP2, MP3) of the liquid flow path. Based on that confirmation, the inventor of the present invention has found that, in a case in which the sulfuric acid and the hydrogen peroxide solution are mixed in the plurality of portions (MP1, MP2, MP3) of the liquid flow path, the concentration of Caro's acid in the processing liquid discharged from the nozzle 30 tends to be high by increasing the mixing ratio of the hydrogen peroxide solution with respect to the sulfuric acid in a downstream portion as compared with an upstream portion.

In addition, the inventor of the present invention has found that the concentration of Caro's acid in the processing liquid generated by mixing the sulfuric acid and the hydrogen peroxide solution at a predetermined mixing ratio in the first portion MP1 and the second portion MP2 tends to be higher than the concentration of Caro's acid in the processing liquid generated by mixing the sulfuric acid and the hydrogen peroxide solution at a predetermined mixing ratio in the first portion MP1 and the third portion MP3. That is, the inventor of the present invention has found that, the farther a portion in which the hydrogen peroxide solution is added in the liquid flow path is located from the nozzle 30, the higher the concentration of Caro's acid in the processing liquid discharged from the nozzle 30 tends to be.

As such, based on the obtained findings, the inventor of the present invention considered setting the work conditions of the processing liquid supply devices 3A, 3B, 3C such that the processing liquid having the film-removal capability corresponding to each of the plurality of portions of the substrate was generated. In other words, the inventor of the present invention considered setting the work conditions of the processing liquid supply devices 3A, 3B, 3C such that the processing liquid having the concentration of Caro's acid corresponding to each of the plurality of portions of the substrate was generated.

### <5> First Specific Example of Plurality of Work Conditions

In the following description, in a case in which the plurality of second sub-pipes 23, 24, 25 of one processing liquid supply device are distinguished from one another, the second sub-pipe 23 is referred to as a "pipe A," the second sub-pipe 24 is referred to as a "pipe B," and the second sub-pipe 25 is referred to as a "pipe C."

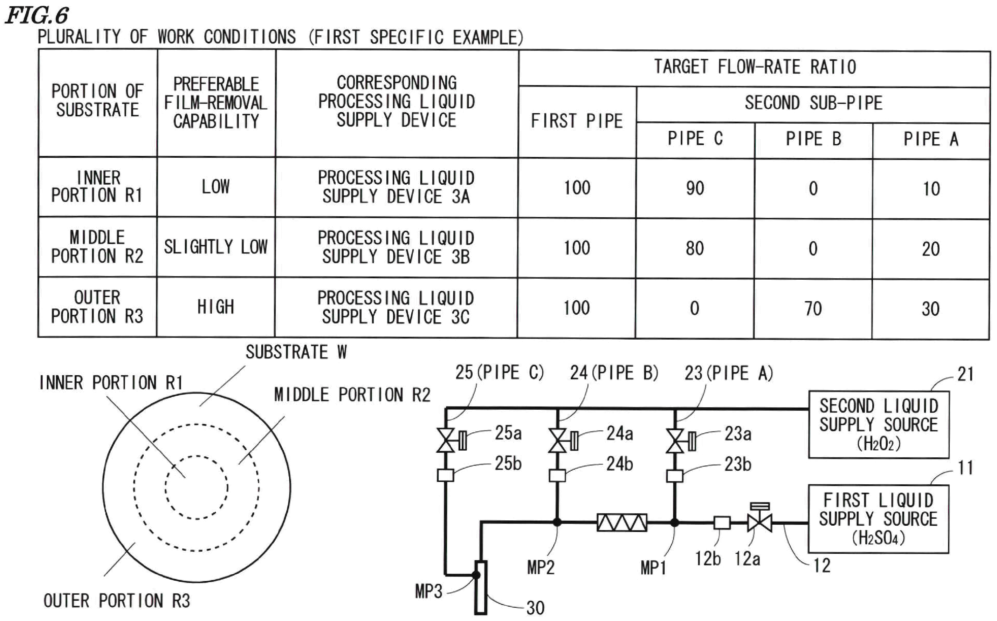

Fig. 6 is a diagram showing a first specific example of the plurality of work conditions set to respectively correspond to the plurality of portions of the substrate W. In Fig. 6, the work conditions of the three processing liquid supply devices 3A, 3B, 3C respectively set for the inner portion R1, the middle portion R2, and the outer portion R3 of the substrate W are shown using a table. Below the table, explanatory diagrams of the plurality of portions of the substrate W are also shown in order to facilitate understanding of the table. Furthermore, the configuration diagram of each of the processing liquid supply devices 3A, 3B, 3C is shown in order to facilitate understanding of the table.

In the first specific example of Fig. 6, the work conditions are set for the substrate W having the resist film in which the inner portion R1 has high removability, the middle portion R2 has slightly high removablity, and the outer portion R3 has low removability. In this case, it is preferable that, in regard to the substrate W, the processing liquid having a low film-removal capability is supplied to the inner portion R1, the processing liquid having a slightly low film-removal capability is supplied to the middle portion R2, and the processing liquid having a high film-removal capability is supplied to the outer portion R3.

As such, in the present example, as the work condition of the processing liquid supply device 3A corresponding to the inner portion R1, the target flow-rate ratio of liquids flowing through the first pipe 12, the pipe A, the pipe B, and the pipe C is set to 100 : 10 : 0 : 90 such that the concentration of Caro's acid in the generated processing liquid is low.

Further, in the present example, as the work condition of the processing liquid supply device 3B corresponding to the middle portion R2, the target flow-rate ratio of liquids flowing through the first pipe 12, the pipe A, the pipe B, and the pipe C is set to 100 : 20 : 0 : 80 such that the concentration of Caro's acid in the generated processing liquid is slightly low.

Further, in the present example, as the work condition of the processing liquid supply device 3C corresponding to the outer portion R3, the target flow-rate ratio of liquids flowing through the first pipe 12, the pipe A, the pipe B, and the pipe C is set to 100 : 30 : 70 : 0 such that the concentration of Caro's acid in the generated processing liquid is high.

As a result, when the substrate processing apparatus 100 works according to the plurality of work conditions of Fig. 6, the valves 12a, 23a, 24a, 25a are in the open state in the processing liquid supply device 3A. Further, the adjusters 12b, 23b, 24b, 25b are respectively controlled such that the flow-rate ratio of liquids flowing through the first pipe 12, the pipe A, the pipe B, and the pipe C is 100 : 10 : 0 : 90, which is a target ratio. In this case, because the target ratio for the pipe B is 0, the valve 24a of the pipe B may be in the close state.

Further, in the processing liquid supply device 3B, the valves 12a, 23a, 24a, 25a are in the open state. Further, the adjusters 12b, 23b, 24b, 25b are respectively controlled such that the flow-rate ratio of liquids flowing through the first pipe 12, the pipe A, the pipe B, and the pipe C is 100 : 20 : 0 : 80, which is a target ratio. In this case, because the target ratio for the pipe B is 0, the valve 24a of the pipe B may be in the close state.

Further, in the processing liquid supply device 3C, the valves 12a, 23a, 24a, 25a are in the open state. Further, the adjusters 12b, 23b, 24b, 25b are respectively controlled such that the flow-rate ratio of liquids flowing through the first pipe 12, the pipe A, the pipe B, and the pipe C is 100 : 30 : 70 : 0, which is a target ratio. In this case, because the target ratio for the pipe C is 0, the valve 25a of the pipe C may be in the close state.

### <6> Second Specific Example of Plurality of Work Conditions

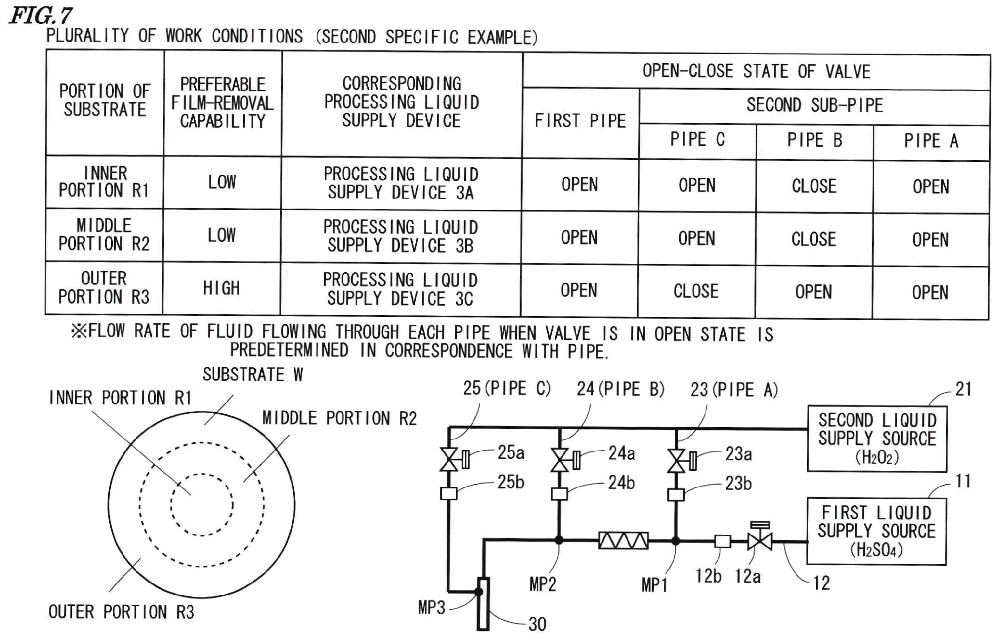

Fig. 7 is a diagram showing a second specific example of the plurality of work conditions set to respectively correspond to the plurality of portions of the substrate W. In Fig. 7, similarly to the example of Fig. 6, the work conditions of the three processing liquid supply devices 3A, 3B, 3C respectively set for the inner portion R1, the middle portion R2, and the outer portion R3 of the substrate W are shown using a table. Below the table, explanatory diagrams of the plurality of portions of the substrate W are also shown in order to facilitate understanding of the table. Furthermore, the configuration diagram of each of the processing liquid supply devices 3A, 3B, 3C is shown in order to facilitate understanding of the table.

In the second specific example of Fig. 7, the work conditions are set for the substrate W having the resist film in which the inner portion R1 has high removability, the middle portion R2 has high removability, and the outer portion R3 has low removability. In this case, it is preferable that, in regard to the substrate W, the processing liquid having a low film-removal capability is supplied to the inner portion R1, the processing liquid having a low film-removal capability is supplied to the middle portion R2, and the processing liquid having a high film-removal capability is supplied to the outer portion R3.

Here, in the present example, in the three processing liquid supply devices 3A, 3B, 3C, when the valve 12a is in the open state, the flow rate of the liquid flowing through the first pipe 12 is predetermined. The flow rates of the liquids flowing through the pipe A, the pipe B, and the pipe C when the valves 23a, 24a, 25a are in the open state are also predetermined. In this case, the concentration of Caro's acid in the processing liquid discharged from the nozzle 30 changes depending on the open-close states of the valve 12a of the first pipe 12, the valve 23a of the pipe A, the valve 24a of the pipe B, and the valve 25a of the pipe C.

As such, in the present example, as the work condition of the processing liquid supply device 3A corresponding to the inner portion R1, the open-close states of the valves 12a, 23a, 24a, 25a are respectively set to "OPEN," "OPEN," "CLOSE," and "OPEN" such that the concentration of Caro's acid in the generated processing liquid is low.

Further, in the present example, as the work condition of the processing liquid supply device 3B corresponding to the middle portion R2, the open-close states of the valves 12a, 23a, 24a, 25a are respectively set to "OPEN," "OPEN," "CLOSE," and "OPEN" such that the concentration of Caro's acid in the generated processing liquid is low.

Further, in the present example, as the work condition of the processing liquid supply device 3C corresponding to the outer portion R3, the open-close states of the valves 12a, 23a, 24a, 25a are respectively set to "OPEN," "OPEN," "OPEN," and "CLOSE" such that the concentration of Caro's acid in the generated processing liquid is high.

As a result, when the substrate processing apparatus 100 works according to the plurality of work conditions of Fig. 7, the valves 12a, 23a, 25a are in the open state, and the valve 24a is in the close state in the processing liquid supply device 3A. Further, in the processing liquid supply device 3B, the valves 12a, 23a, 25a are in the open state, and the valve 24a is in the close state. Further, in the processing liquid supply device 3C, the valves 12a, 23a, 24a are in the open state, and the valve 25a is in the close state. The plurality of adjusters 12b, 23b, 24b, 25b are controlled to be in states respectively corresponding to the flow rates predetermined for the first pipe 12, the pipe A, the pipe B, and the pipe C.

### <7> Film Removal Process by Controller 6

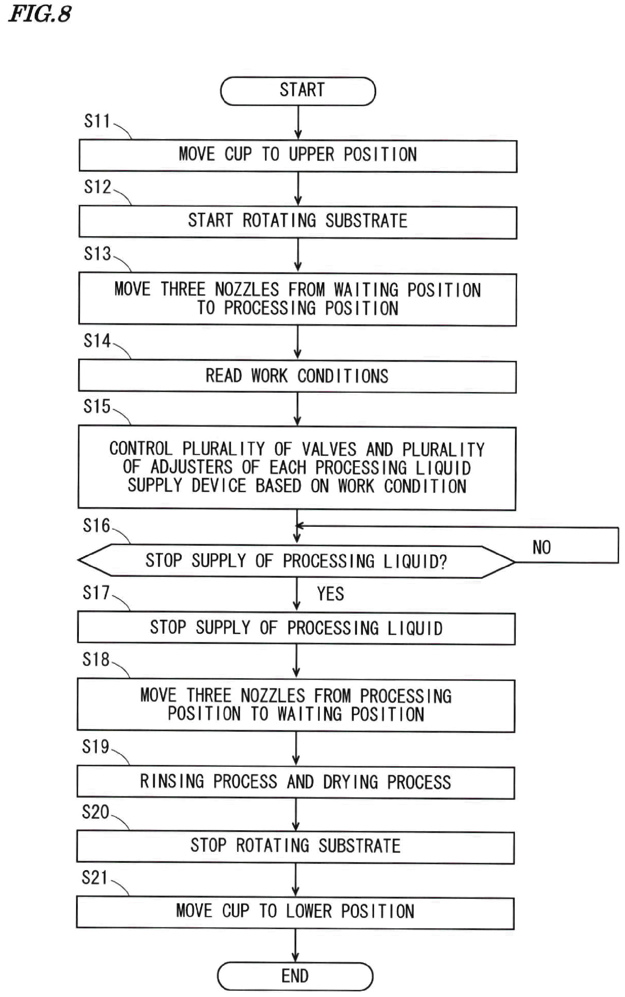

Fig. 8 is a flowchart illustrating one example of a film removal process executed by the controller 6 of Fig. 1. The below-mentioned film removal process is executed when the CPU 61 of the controller 6 executes, on the RAM 62, a film removal program stored in the storage device 64.

The film removal process executed by the controller 6 is started in response to, for example, an unprocessed substrate W (the substrate W having the resist film formed on the entire surface thereof) being carried into the chamber of the substrate processing apparatus 100 and placed on the spin chuck 1. In an initial state, the cup 2 is located at the lower position, and the plurality of nozzles 30 are located at the waiting position WP. Further, all of the plurality of valves 12a, 23a, 24a, 25a of each of the three processing liquid supply devices 3A, 3B, 3C are kept in the close state. Further, in the storage device 64 of the controller 6, a plurality of work conditions of the three processing liquid supply devices 3A, 3B, 3C respectively corresponding to the plurality of portions (the inner portion R1, the middle portion R2, and the outer portion R3) of the substrate W to be processed are stored.

When the film removal process is started, the CPU 61 controls the cup lifting-lowering device 2D to move the cup 2 from the lower position to the upper position (step S11). Further, the CPU 61 controls the spin motor 1a to rotate the substrate W held by the plurality of chuck pins 1c on the spin base 1b (step S12). Further, the CPU 61 controls the nozzle moving device 5 to move the three nozzles 30 of the three processing liquid supply device 3A, 3B, 3C from the waiting position WP to the processing position PP (step S13).

Subsequently, the CPU 61 reads the plurality of work conditions stored in the storage device 64 (step S14). Next, the CPU 61 controls the plurality of valves 12a, 23a, 24a, 25a and the plurality of adjusters 12b, 23b, 24b, 25b of the three processing liquid supply devices 3A, 3B, 3C based on the plurality of read work conditions (step S15). Thus, the processing liquids having the corresponding film-removal capabilities are respectively supplied to the inner portion R1, the middle portion R2, and the outer portion R3 of the substrate W.

In the present example, a supply period of time during which the processing liquid for removing the resist film is supplied is predetermined. As such, the CPU 61 measures an elapsed period of time from a start point in time of the process of the step S15. Further, based on whether the measured period of time has reached the predetermined supply period of time, the CPU 61 determines whether to stop the supply of the processing liquid (step S16).

In a case in which the supply of the processing liquid is not to be stopped, the CPU 61 repeats the process of the step S16. On the other hand, in a case in which the supply of the processing liquid is to be stopped, the CPU 61 closes the plurality of valves 12a, 23a, 24a, 25a of the three processing liquid supply devices 3A, 3B, 3C to stop the supply of the processing liquid (step S17).

Next, the CPU 61 controls the nozzle moving device 5 to move the three nozzles 30 of the three processing liquid supply devices 3A, 3B, 3C from the processing position PP to the waiting position WP (step S18). Further, by controlling a rinse liquid supply system (not shown) and the spin motor 1a, the CPU 61 executes the rinsing process and a drying process on the substrate W from which the resist film has been removed (step S19). The drying process in the step S19 is a so-called spin drying process of rotating the substrate W at a high speed after the rinsing process to dry the substrate W.

After the drying process in the step S19 ends, the CPU 61 controls the spin motor 1a to stop rotation of the substrate W (step S20). Further, the CPU 61 controls the cup lifting-lowering device 2D to move the cup 2 from the upper position to the lower position (step S21), and ends a series of processes.

### <8> Effects

(a) In the substrate processing method according to the present embodiment, in regard to each of the plurality of portions of the one surface of the substrate W, the substrate portion information is acquired as the information relating to the film-removal capability of the processing liquid to be supplied to the portion. Based on the substrate portion information, the work conditions of the three processing liquid supply devices 3A, 3B, 3C are set in the substrate processing apparatus 100.

During the removal process by the substrate processing apparatus 100, the three processing liquid supply devices 3A, 3B, 3C are controlled so as to follow the plurality of work conditions respectively corresponding to the plurality of portions (the inner portion R1, the middle portion R2, and the outer portion R3) of the one surface of the substrate W. By appropriately setting the plurality of work conditions, the processing liquids having appropriate film-removal capabilities for removing the resist film are respectively supplied to the plurality of portions of the one surface of the substrate W and impinge on the resist film. The film-removal capability of the processing liquid is most effective when the processing liquid is discharged from the nozzle 30 and reaches (impinges on) the resist film on the substrate W. This suppresses remaining of the unnecessary resist film in a portion of the one surface of the substrate W and damage to the portion of the one surface of the substrate W. Further, it is not necessary to supply a large amount of the processing liquid to the portion in order to remove the resist film formed on a portion of the substrate W having low removability.

As a result, it is possible to remove the unnecessary resist film formed on the one surface of the substrate W without damaging the one surface of the substrate W, and reduce an amount of the processing liquid to be used.

(b) In the above-mentioned substrate processing apparatus 100, the three processing liquid supply devices 3A, 3B, 3C are used so as to respectively correspond to the three portions of the substrate W. The three nozzles 30 of the three processing liquid supply devices 3A, 3B, 3C are moved between the waiting position WP and the processing position PP by the nozzle supporter 4 and the nozzle moving device 5. With the three nozzles 30 disposed at the processing position PP, the three nozzles 30 are respectively opposite to the inner portion R1, the middle portion R2, and the outer portion R3 of the one surface of the substrate W. Therefore, by causing the three processing liquid supply devices 3A, 3B, 3C to work at the same time, it is possible to supply the processing liquid from the three nozzles 30 to the plurality of portions (the inner portion R1, the middle portion R2, and the outer portion R3) of the substrate W at the same time. This can shorten a period of time required for the removal process as compared with a case in which the processing liquid is sequentially supplied to the plurality of portions of the one surface of the substrate W using one nozzle 30. As a result, it prevents contamination of the substrate W such as adhesion of particles caused by an increase in processing period of time.

### <9> Other Embodiments

(a) While the substrate processing apparatus 100 according to the above-mentioned embodiment includes the processing liquid supply devices 3A, 3B, 3C respectively corresponding to the inner portion R1, the middle portion R2, and the outer portion R3 of the substrate W, the present invention is not limited to this.

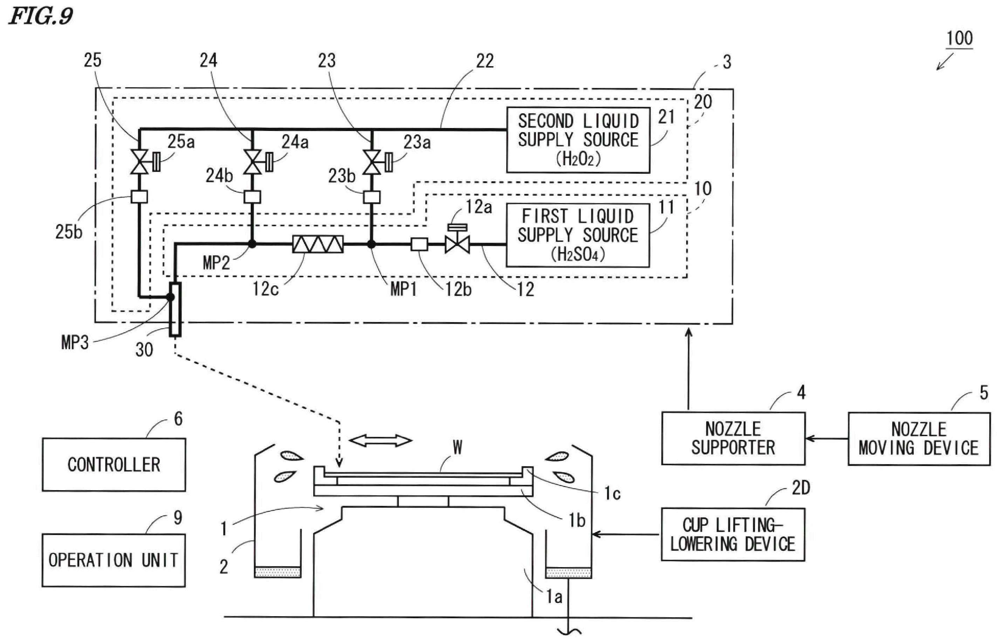

The substrate processing apparatus 100 may include only one processing liquid supply device. Fig. 9 is a schematic diagram showing the configuration of a substrate processing apparatus 100 according to another embodiment. The substrate processing apparatus 100 of Fig. 9 includes only one processing liquid supply device 3 as a configuration for supplying the processing liquid to the substrate W. In the substrate processing apparatus 100 of Fig. 7, the arm member 7 (see Fig. 2) of the processing liquid supply device 3 is moved in the rail direction during the removal process. This causes the processing liquid discharged from one nozzle 30 to be sequentially supplied to the plurality of portions of the one surface of the substrate W.

Here, also in the present example, before the removal process is executed, a plurality of work conditions respectively corresponding to the plurality of portions of the substrate W are set in the substrate processing apparatus 100. Thus, during the removal process, the control of the work state of each component of the processing liquid supply device 3 is switched according to a portion of the substrate W to which the nozzle 30 is opposite.

For example, suppose that the plurality of work conditions of Fig. 6 are set in the substrate processing apparatus 100 of Fig. 9. In this case, after the removal process is started, the nozzle 30 is positioned so as to be opposite to the inner portion R1 of the substrate W, for example. In this state, the valves 12a, 23a, 24a, 25a are in the open state. Further, the adjusters 12b, 23b, 24b, 25b are respectively controlled such that the flow-rate ratio of liquids flowing through the first pipe 12, the pipe A, the pipe B, and the pipe C is 100 : 10 : 0 : 90, which is a target ratio.

Next, when the removal of the resist film in the inner portion R1 of the substrate W is completed, the nozzle 30 is positioned so as to be opposite to the middle portion R2 of the substrate W. In this state, the valves 12a, 23a, 24a, 25a are in the open state. Further, the adjusters 12b, 23b, 24b, 25b are respectively controlled such that the flow-rate ratio of liquids flowing through the first pipe 12, the pipe A, the pipe B, and the pipe C is 100 : 20 : 0 : 80, which is a target ratio.

Next, when the removal of the resist film in the middle portion R2 of the substrate W is completed, the nozzle 30 is positioned so as to be opposite to the outer portion R3 of the substrate W. In this state, the valves 12a, 23a, 24a, 25a are in the open state. Further, the adjusters 12b, 23b, 24b, 25b are respectively controlled such that the flow-rate ratio of liquids flowing through the first pipe 12, the pipe A, the pipe B, and the pipe C is 100 : 30 : 70 : 0, which is a target ratio.

As described above, in the substrate processing apparatus 100 of Fig. 9, the processing liquid having an appropriate film-removal capability is sequentially supplied to the inner portion R1, the middle portion R2, and the outer portion R3 of the substrate W by moving the one processing liquid supply device 3. Therefore, it is not necessary to provide a plurality of processing liquid supply devices 3 in the substrate processing apparatus 100. This suppresses an increase in number of components, and simplifies the configuration, in regard to the substrate processing apparatus 100 of Fig. 9.

(b) While the three processing liquid supply devices 3A, 3B, 3C respectively have independent configurations in the substrate processing apparatus 100 according to the above-mentioned embodiment, the present invention is not limited to this. The configuration of part of the three processing liquid supply devices 3A, 3B, 3C may be commonly used among the three processing liquid supply devices 3A, 3B, 3C.

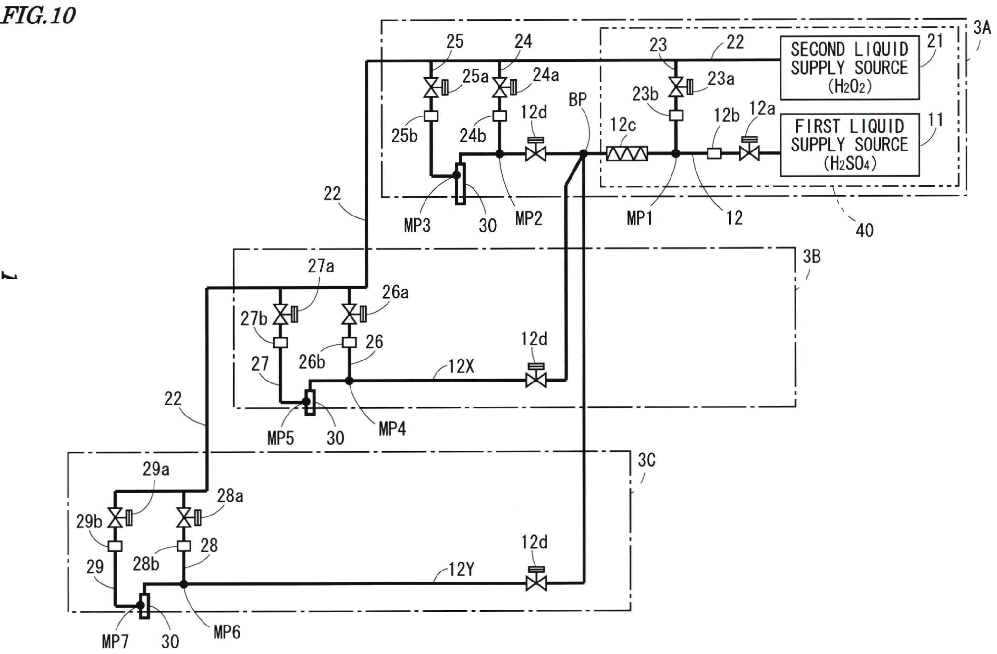

Fig. 10 is a diagram showing one example of a configuration of three processing liquid supply devices 3A, 3B, 3C according to another embodiment. Differences of the configuration of the three processing liquid supply devices 3A, 3B, 3C of Fig. 10 from the configuration of the three processing liquid supply devices 3A, 3B, 3C of Fig. 1 will be described.

In the processing liquid supply device 3A of Fig. 10, a branch portion BP is provided between the stirrer 12c and the second portion MP2 in the first pipe 12. A valve 12d is provided between the branch portion BP and the second portion MP2 in the first pipe 12. Upstream ends of two first pipes 12X, 12Y, which are drawn out of the processing liquid supply device 3A and respectively extend to the processing liquid supply device 3B and the processing liquid supply device 3C, are connected to the branch portion BP of the first pipe 12. Further, in the processing liquid supply device 3A of Fig. 10, the second main pipe 22 is drawn out from the second liquid supply source 21 to the outside of the processing liquid supply device 3A.

In the processing liquid supply device 3B of Fig. 10, the nozzle 30 is connected to a downstream end of the first pipe 12X drawn out from the processing liquid supply device 3A. In the first pipe 12X, a valve 12d is provided similarly to the valve 12d of the processing liquid supply device 3A. In a liquid flow path formed by the first pipe 12X and the nozzle 30, a portion located between the valve 12d and the nozzle 30 is referred to as a fourth portion MP4. Further, a portion located in the nozzle 30 is referred to as a fifth portion MP5.

A portion of the second main pipe 22 drawn out from the processing liquid supply device 3A is guided into the processing liquid supply device 3B, and is further drawn out from the processing liquid supply device 3B. Therefore, part of the second main pipe 22 forms part of the processing liquid supply device 3B. Two branch portions are provided in a portion of the second main pipe 22 forming part of the processing liquid supply device 3B. Two second sub-pipes 26, 27 are connected so as to respectively connect the two branch portions of the second main pipe 22 to the fourth portion MP4 and the fifth portion MP5 of the liquid flow path. A valve 26a and an adjuster 26b are provided in the second sub-pipe 26, and a valve 27a and an adjuster 27b are provided in the second sub-pipe 27.

In the processing liquid supply device 3C of Fig. 10, the nozzle 30 is connected to a downstream end of the first pipe 12Y drawn out from the processing liquid supply device 3A. In the first pipe 12Y, a valve 12d is provided similarly to the valve 12d of the processing liquid supply device 3A. In the liquid flow path formed by the first pipe 12Y and the nozzle 30, a portion located between the valve 12d and the nozzle 30 is referred to as a sixth portion MP6. Further, a portion located in the nozzle 30 is referred to as a seventh portion MP7.

A portion of the second main pipe 22 drawn out from the processing liquid supply device 3B is guided into the processing liquid supply device 3C. A downstream end of the second main pipe 22 is located in the processing liquid supply device 3C. Therefore, a portion including the downstream end of the second main pipe 22 forms part of the processing liquid supply device 3C. One branch portion is provided in a portion of the second main pipe 22 forming part of the processing liquid supply device 3C. Two second sub-pipes 28, 29 are connected so as to respectively connect the one branch portion and the downstream end of the second main pipe 22 to the sixth portion MP6 and the seventh portion MP7 of the liquid flow path. A valve 28a and an adjuster 28b are provided in the second sub-pipe 28, and a valve 29a and an adjuster 29b are provided in the second sub-pipe 29.

In the three processing liquid supply devices 3A, 3B, 3C of Fig. 10 having the above-mentioned configuration, as indicated by the frame of the two-dots and dash line, the configuration of part of the processing liquid supply device 3A is commonly used as a common supply system 40 in the other processing liquid supply devices 3B, 3C.

Thus, by opening the valves 12a, 23a in the common supply system 40, the sulfuric acid and the hydrogen peroxide solution can be mixed in the stirrer 12c. Further, by selectively switching the valves 12d of the three processing liquid supply devices 3A, 3B, 3C, it is possible to selectively supply, to the three nozzles 30, the processing liquid (the mixed liquid of the sulfuric acid and the hydrogen peroxide solution) that has passed through the stirrer 12c.

Further, by switching the open-close states of the valves 24a, 25a, 26a, 27a, 28a, 29a of the three processing liquid supply devices 3A, 3B, 3C, it is possible to switch between presence and absence of supply of the hydrogen peroxide solution from the second liquid supply source 21 to each liquid flow path. With the configuration of Fig. 10, since part of the configuration of the three processing liquid supply devices 3A, 3B, 3C is commonly used, it suppresses an increase in number of components of the substrate processing apparatus 100, and simplifies the configuration.

(c) In the substrate processing apparatus 100 according to the above-mentioned embodiment, the three processing liquid supply devices 3A, 3B, 3C may be moved in a horizontal plane so as to be opposite to three or more portions on the substrate W during the removal process.

For example, after supplying the processing liquid to the three portions on the substrate W from the three nozzles 30, the three processing liquid supply devices 3A, 3B, 3C may be horizontally moved such that the three nozzles 30 are opposite to other three portions on the substrate W. In this case, the processing liquid can be further supplied to the other three portions on the substrate W. This enables the processing liquid having an appropriate film-removal capability to be supplied to more portions on the substrate W.

(b) While the substrate processing apparatus 100 according to the above-mentioned embodiment has three processing liquid supply devices 3A, 3B, 3C, the present invention is not limited to this. The substrate processing apparatus 100 may have two processing liquid supply devices, or may have four or more processing liquid supply devices. In this case, the larger the number of the processing liquid supply devices, the larger the number of portions on the substrate W that can be processed at the same time. This improves the efficiency of processing the substrate W. On the other hand, the smaller the number of the processing liquid supply devices, the more suppressed an increase in number of components of the substrate processing apparatus 100. This simplifies the configuration.

(e) In each of the processing liquid supply devices 3A, 3B, 3C of the substrate processing apparatus 100 according to the above-mentioned embodiment, the first liquid supply source 11 is the supply source of the sulfuric acid, and the second liquid supply source 21 is the supply source of the hydrogen peroxide solution. However, the present invention is not limited to this. In the above-mentioned processing liquid supply devices 3A, 3B, 3C, the first liquid supply source 11 may be the supply source of the hydrogen peroxide solution, and the second liquid supply source 21 may be the supply source of the sulfuric acid.

(f) While the second liquid supply system 20 of each of the processing liquid supply devices 3A, 3B, 3C according to the above-mentioned embodiment includes the three second sub-pipes 23, 24, 25 as the pipes for mixing the hydrogen peroxide solution with the sulfuric acid, the present invention is not limited to this. The second liquid supply system 20 may include only two second sub-pipes or may include four or more second sub-pipes. In a case in which the second liquid supply system 20 has four or more second sub-pipes, the sulfuric acid and the hydrogen peroxide solution can be mixed in four or more portions of the liquid flow path formed by the first pipe 12 and the nozzle 30. This improves a degree of freedom of the work condition that can be set for generating the processing liquid.

(f) While the sulfuric acid and the hydrogen peroxide solution are mixed in the two portions among the first portion MP1, the second portion MP2, and the third portion MP3 of the liquid flow path in order to generate the processing liquid in each of the processing liquid supply devices 3A, 3B, 3C in the above-mentioned embodiment, the present invention is not limited to this. The processing liquid may be generated by mixing the sulfuric acid and the hydrogen peroxide solution in all portions of the first portion MP1, the second portion MP2, and the third portion MP3 of the liquid flow path.

(h) While the rinsing process and the drying process are executed in this order after the processing liquid including Caro's acid is supplied to the substrate W in the film removal process according to the above-mentioned embodiment, the present invention is not limited to this. The substrate processing apparatus 100 may include a supply device (SC1 supply device) that supplies, to the substrate W held by the spin chuck 1, a mixed liquid (SC1) of ammonium water and a hydrogen peroxide solution as another processing liquid. In this case, between the above-mentioned rinsing process and the above-mentioned drying process, the SC1 supply device may supply the SC1 to the substrate W and may stop supplying the SC1 to the substrate W, and an additional rinsing process for washing away the SC1 remaining on the substrate W may be executed.

### <10> Correspondences Between Constituent Elements in Claims and Parts in Preferred Embodiments

In the following paragraphs, non-limiting examples of correspondences between various elements recited in the claims below and those described above with respect to various preferred embodiments of the present disclosure are explained. As each of various elements recited in the claims, various other elements having configurations or functions described in the claims can be also used.

In the above-mentioned embodiment, the substrate processing apparatus 100 is an example of a substrate processing apparatus, the nozzle 30 is an example of a nozzle, the first pipe 12 is an example of a first pipe, the first liquid supply system 10 is an example of a first liquid supply system, the plurality of second sub-pipes 23, 24, 25 are an example of a plurality of second pipes, the second liquid supply system 20 is an example of a second liquid supply system, and the controller 6 is an example of a controller.

Further, the adjuster 12b is an example of a first flow-rate adjuster, the adjusters 23b, 24b, 25b are examples of a second flow-rate adjuster, the valves 23a, 24a, 25a are an example of a plurality of open-close valves, and the three nozzles 30 of the three processing liquid supply devices (3A, 3B, 3C) are an example of a plurality of nozzles.

Further, the three first liquid supply systems 10 of the three processing liquid supply devices (3A, 3B, 3C) are an example of a plurality of first liquid supply systems, the three second liquid supply systems 20 of the three processing liquid supply devices (3A, 3B, 3C) are an example of a plurality of second liquid supply systems, the nozzle supporter 4 is an example of a nozzle supporter, the nozzle moving device 5 is an example of a nozzle mover, and the substrate portion information is an example of information relating to a film-removal capability of a processing liquid.

### <11> <Overview of Embodiments>

(Item 1) A substrate processing apparatus according to item 1 executes a removal process of removing, using a processing liquid including Caro's acid, an unnecessary film formed on one surface of a substrate, wherein in a case in which one of sulfuric acid and a hydrogen peroxide solution is a first liquid, and another one of the sulfuric acid and the hydrogen peroxide solution is a second liquid, the Caro's acid is generated by mixing the first liquid and the second liquid, the substrate processing apparatus includes a nozzle that discharges the processing liquid such that the processing liquid impinges on a plurality of portions on the one surface of the substrate, a first liquid supply system that includes a first pipe connected to the nozzle, and supplies the first liquid to the nozzle through the first pipe, a second liquid supply system that includes a plurality of second pipes respectively connected to a plurality of different portions of a liquid flow path formed by the nozzle and the first pipe, and supplies the second liquid to the liquid flow path through any one of the plurality of second pipes, and a controller that controls the first liquid supply system and the second liquid supply system based on a plurality of predetermined work conditions during the removal process, and the plurality of work conditions are respectively associated with the plurality of portions of the substrate such that a processing liquid having a film-removal capability corresponding to each portion of the plurality of portions of the one surface of the substrate impinges on the portion.

In the substrate processing apparatus, the first liquid is supplied to the nozzle through the first pipe of the first liquid supply system. Further, the second liquid is supplied into the first pipe through any one of the plurality of second pipes of the second liquid supply system. In this case, the first liquid flowing through the first pipe and the second liquid are mixed in any one of the plurality of portions of the first pipe. This causes the processing liquid including Caro's acid to be generated in the first pipe and discharged from the nozzle.

The first liquid supply system and the second liquid supply system are controlled to work according to the plurality of work conditions during the removal process. This causes the processing liquid having the film-removal capability corresponding to each of the plurality of portions of the one surface of the substrate to impinge on the portion. A degree of the film-removal capability of the processing liquid indicates a degree of reactivity of the processing liquid with respect to the film on the substrate, and is mainly determined by a concentration of Caro's acid included in the processing liquid.

On the other hand, degrees of how likely the unnecessary film is removed (removability) during the removal process in the plurality of portions of the one surface of the substrate may be different depending on a material forming the film, a film-thickness distribution, the adhesion between the film and the substrate, and the like. The distribution of removability in the substrate to be processed can be identified to some extent by executing the removal process on a sample substrate in advance or executing a simulation.

In a case in which the distribution of removability can be identified, the film-removal capability of the processing liquid to be supplied to each of the plurality of portions of the one surface of the substrate can be predicted according to the distribution. For example, the processing liquid having a high film-removal capability is supplied to a portion of the substrate having low removability (the film is unlikely to be removed). This can suppress remaining of the unnecessary film while reducing a period of time required to process the portion. On the other hand, the processing liquid having a low film-removal capability is supplied to a portion of the substrate having high removability (the film is likely to be removed). This can suppress damage to an underlying portion of the film as the film is removed.

With the above-mentioned configuration, the first liquid supply system and the second liquid supply system are controlled so as to follow the plurality of work conditions respectively corresponding to the plurality of portions of the one surface of the substrate. By appropriately setting the plurality of work conditions, the processing liquids having appropriate film-removal capabilities for removing the film are respectively supplied to the plurality of portions of the one surface of the substrate. This suppresses remaining of part of the unnecessary resist film in a portion of the one surface of the substrate and damage to the portion of the one surface of the substrate. Further, it is not necessary to supply a large amount of the processing liquid to a portion of the substrate having low removability in order to remove the film formed on the portion.

As a result, it is possible to remove the unnecessary film formed on the one surface of the substrate without damaging the one surface of the substrate, and reduce an amount of the processing liquid to be used.

(Item 2) The substrate processing apparatus according to item 1, wherein the first liquid supply system may include a first flow-rate adjuster that adjusts a flow rate of the first liquid flowing through the first pipe, the second liquid supply system may include a plurality of second flow-rate adjusters that respectively adjust flow rates of the second liquid respectively flowing through the plurality of second pipes, the plurality of work conditions may include a plurality of target ratios associated with a flow rate of the second liquid flowing through each second pipe and a flow rate of the first liquid flowing through the first pipe, with the plurality of target ratios respectively corresponding to the plurality of portions of the one surface of the substrate, and the controller may control the first flow-rate adjuster and the plurality of second flow-rate adjusters such that, for each portion of the substrate on which the processing liquid discharged from the nozzle is to impinge during the removal process, a ratio of a flow rate of the second liquid flowing through each second pipe and a flow rate of the first liquid flowing through the first pipe is the target ratio associated with the portion.

The degree of film-removal capability of the processing liquid discharged from the nozzle to the substrate is determined according to the ratio between the flow rate of the second liquid flowing through each second pipe and the flow rate of the first liquid flowing through the first pipe. Therefore, by appropriately setting the plurality of target ratios corresponding to the plurality of portions of the one surface of the substrate, the processing liquids having the appropriate film-removal capabilities for removing the film are respectively supplied to the plurality of portions of the one surface of the substrate.

(Item 3) The substrate processing apparatus according to item 1, wherein the second liquid supply system may further include a plurality of open-close valves respectively provided in the plurality of second pipes, the plurality of work conditions may include open-close states of the plurality of open-close valves associated with each of the plurality of portions of the one surface of the substrate, and the controller may control the plurality of open-close valves such that, for each portion of the substrate on which the processing liquid discharged from the nozzle is to impinge during the removal process, open-close states of the plurality of open-close valves correspond to the portion.

The degree of film-removal capability of the processing liquid discharged from the nozzle to the substrate is determined according to from which pipe among the plurality of second pipes the second liquid is supplied to the first pipe. Therefore, by appropriately setting the plurality of open-close states corresponding to the plurality of portions of the one surface of the substrate, the processing liquids having appropriate film-removal capabilities for removing the film are respectively supplied to the plurality of portions of the one surface of the substrate.

(Item 4) The substrate processing apparatus according to items 1 to 3, wherein the nozzle may include a plurality of nozzles respectively corresponding to the plurality of portions of the one surface of the substrate, the first liquid supply system may include a plurality of first liquid supply systems respectively corresponding to the plurality of nozzles, the second liquid supply system may include a plurality of second liquid supply systems respectively corresponding to the plurality of nozzles, and the substrate processing apparatus may further include a nozzle supporter that supports the plurality of nozzles such that discharge ports of the plurality of nozzles through which the processing liquid is discharged are respectively opposite to the plurality of portions of the one surface of the substrate.

In this case, by causing the plurality of first liquid supply systems and the plurality of second liquid supply systems to work at the same time, it is possible to supply the processing liquid from the plurality of nozzles to the plurality of portions of the substrate at the same time. This can shorten a period of time required for the removal process as compared with a case in which the processing liquid is sequentially supplied to the plurality of portions of the one surface of the substrate using one nozzle. This prevents contamination of the substrate such as adhesion of particles caused by an increase in processing period of time.

(Item 5) The substrate processing apparatus according to items 1 to 3, may further include a nozzle mover that supports the nozzle at a position above the substrate, and relatively moves the nozzle and the substrate with respect to each other in a horizontal plane, and the controller may control the nozzle mover such that the processing liquid discharged from the nozzle sequentially impinges on the plurality of portions of the one surface of the substrate during the removal process.

In this case, it is not necessary to prepare a plurality of nozzles in order to discharge the processing liquid to the plurality of portions of the substrate. This suppresses an increase in number of components of the substrate processing apparatus and simplifies the configuration.

(Item 6) A substrate processing method according to item 6 is executed using a substrate processing apparatus, with the substrate processing apparatus executing a removal process of removing, using a processing liquid including Caro's acid, an unnecessary film formed on one surface of a substrate, wherein in a case in which one of sulfuric acid and a hydrogen peroxide solution is a first liquid, and another one of the sulfuric acid and the hydrogen peroxide solution is a second liquid, the Caro's acid is generated by mixing the first liquid and the second liquid, the substrate processing apparatus includes a nozzle that discharges the processing liquid such that the processing liquid impinges on a plurality of portions on the one surface of the substrate, a first liquid supply system that includes a first pipe connected to the nozzle, and supplies the first liquid to the nozzle through the first pipe, and a second liquid supply system that includes a plurality of second pipes respectively connected to a plurality of different portions of a liquid flow path formed by the nozzle and the first pipe, and supplies the second liquid into the first pipe through any one of the plurality of second pipes, and the substrate processing method includes the steps of, in regard to each portion of the plurality of portions of the one surface of the substrate, acquiring information relating to a film-removal capability of the processing liquid to be supplied to the portion, based on the acquired information, setting work conditions of the first liquid supply system and the second liquid supply system corresponding to each of the plurality of portions of the substrate such that processing liquids having respectively corresponding film-removal capabilities impinge on the plurality of portions of the one surface of the substrate, and controlling the first liquid supply system and the second liquid supply system based on the set work conditions of the first liquid supply system and the second liquid supply system.

Degrees of how likely the unnecessary film is removed (removability) during the removal process in the plurality of portions of the one surface of the substrate may be different depending on a material forming the film, a film-thickness distribution, the adhesion between the film and the substrate, and the like. The distribution of removability in the substrate to be processed can be identified to some extent by executing the removal process on a sample substrate in advance or executing a simulation.

In a case in which the distribution of removability can be identified, the film-removal capability of the processing liquid to be supplied to each of the plurality of portions of the one surface of the substrate can be predicted according to the distribution. For example, the processing liquid having a high film-removal capability is supplied to a portion of the substrate having low removability (the film is unlikely to be removed). This can suppress remaining of the unnecessary film while reducing a period of time required to process the portion. On the other hand, the processing liquid having a low film-removal capability is supplied to a portion of the substrate having high removability (the film is likely to be removed). This can suppress damage to an underlying portion of the film as the film is removed. A degree of the film-removal capability of the processing liquid indicates a degree of reactivity of the processing liquid with respect to the film on the substrate, and is mainly determined by a concentration of Caro's acid included in the processing liquid.

With the above-mentioned substrate processing method, in regard to each of the plurality of portions of the one surface of the substrate, the information relating to the film-removal capability of the processing liquid to be supplied to the portion is acquired. Based on the acquired information relating to the film-removal capability of the processing liquid, the work conditions of the first liquid supply system and the second liquid supply system are set. The first liquid supply system and the second liquid supply system are controlled so as to follow the plurality of work conditions respectively corresponding to the plurality of portions of the one surface of the substrate.

When the first liquid supply system and the second liquid supply system are controlled, the first liquid is supplied to the nozzle through the first pipe of the first liquid supply system. Further, the second liquid is supplied into the first pipe through any one of the plurality of second pipes of the second liquid supply system. In this case, the first liquid flowing through the first pipe and the second liquid are mixed in any one of the plurality of portions of the first pipe. The processing liquid including Caro's acid is generated in the first pipe and discharged from the nozzle. This causes the processing liquid having the film-removal capability corresponding to each of the plurality of portions of the one surface of the substrate to impinge on the portion.

By appropriately setting the plurality of work conditions, the processing liquids having appropriate film-removal capabilities for removing the film are respectively supplied to the plurality of portions of the one surface of the substrate. This suppresses remaining of part of the unnecessary resist film in a portion of the one surface of the substrate and damage to the portion of the one surface of the substrate. Further, it is not necessary to supply a large amount of the processing liquid to a portion of the substrate having low removability in order to remove the film formed on the portion.

As a result, it is possible to remove the unnecessary film formed on the one surface of the substrate without damaging the one surface of the substrate, and reduce an amount of the processing liquid to be used.

(Item 7) The substrate processing method according to item 6, wherein the plurality of work conditions may include a plurality of target ratios associated with a flow rate of the second liquid flowing through each second pipe and a flow rate of the first liquid flowing through the first pipe, with the plurality of target ratios respectively corresponding to the plurality of portions of the one surface of the substrate, and the step of controlling the first liquid supply system and the second liquid supply system may include adjusting a flow rate of the first liquid flowing through the first pipe and respectively adjusting flow rates of the second liquid respectively flowing through the plurality of second pipes such that, for each portion of the substrate on which the processing liquid discharged from the nozzle is to impinge during the removal process, a ratio between a flow rate of the second liquid flowing through each second pipe and the flow rate of the first liquid flowing through the first pipe is the target ratio associated with the portion.

The degree of film-removal capability of the processing liquid discharged from the nozzle to the substrate is determined according to the ratio between the flow rate of the second liquid flowing through each second pipe and the flow rate of the first liquid flowing through the first pipe. Therefore, by appropriately setting the plurality of target ratios corresponding to the plurality of portions of the one surface of the substrate, the processing liquids having the appropriate film-removal capabilities for removing the film are respectively supplied to the plurality of portions of the one surface of the substrate.

(Item 8) The substrate processing method according to item 6, wherein the second liquid supply system may further include a plurality of open-close valves respectively provided in the plurality of second pipes, the plurality of work conditions may include open-close states of the plurality of open-close valves associated with each of the plurality of portions of the one surface of the substrate, and the step of controlling the first liquid supply system and the second liquid supply system may include controlling the plurality of open-close valves such that, for each portion of the substrate on which the processing liquid discharged from the nozzle is to impinge during the removal process, open-close states of the plurality of open-close valves correspond to the portion.

The degree of film-removal capability of the processing liquid discharged from the nozzle to the substrate is determined according to from which pipe among the plurality of second pipes the second liquid is supplied to the first pipe. Therefore, by appropriately setting the plurality of open-close states corresponding to the plurality of portions of the one surface of the substrate, the processing liquids having appropriate film-removal capabilities for removing the film are respectively supplied to the plurality of portions of the one surface of the substrate.

(Item 9) The substrate processing method according to any one of items 6 to 8, wherein the nozzle may include a plurality of nozzles respectively corresponding to the plurality of portions of the one surface of the substrate, the first liquid supply system may include a plurality of first liquid supply systems respectively corresponding to the plurality of nozzles, the second liquid supply system may include a plurality of second liquid supply systems respectively corresponding to the plurality of nozzles, and the substrate processing method may include the step of supporting the plurality of nozzles such that discharge ports of the plurality of nozzles through which the processing liquid is discharged are respectively opposite to the plurality of portions of the one surface of the substrate.

In this case, by causing the plurality of first liquid supply systems and the plurality of second liquid supply systems to work at the same time, it is possible to supply the processing liquid from the plurality of nozzles to the plurality of portions of the substrate at the same time. This can shorten a period of time required for the removal process as compared with a case in which the processing liquid is sequentially supplied to the plurality of portions of the one surface of the substrate using one nozzle. This prevents contamination of the substrate such as adhesion of particles caused by an increase in processing period of time.

(Item 10) The substrate processing method according to items 6 to 8, may further include the step of supporting the nozzle at a position above the substrate and relatively moving the nozzle and the substrate with respect to each other in a horizontal plane such that the processing liquid discharged from the nozzle sequentially impinges on the plurality of portions of the one surface of the substrate during the removal process.

In this case, it is not necessary to prepare a plurality of nozzles in order to discharge the processing liquid to the plurality of portions of the substrate. This suppresses an increase in number of components of the substrate processing apparatus and simplifies the configuration.

## Claims

1. A substrate processing apparatus that executes a removal process of removing, using a processing liquid including Caro's acid, an unnecessary film formed on one surface of a substrate, wherein
in a case in which one of sulfuric acid and a hydrogen peroxide solution is a first liquid, and another one of the sulfuric acid and the hydrogen peroxide solution is a second liquid, the Caro's acid is generated by mixing the first liquid and the second liquid,
the substrate processing apparatus includes
a nozzle that discharges the processing liquid such that the processing liquid impinges on a plurality of portions on the one surface of the substrate,
a first liquid supply system that includes a first pipe connected to the nozzle, and supplies the first liquid to the nozzle through the first pipe,
a second liquid supply system that includes a plurality of second pipes respectively connected to a plurality of different portions of a liquid flow path formed by the nozzle and the first pipe, and supplies the second liquid to the liquid flow path through any one of the plurality of second pipes, and
a controller that controls the first liquid supply system and the second liquid supply system based on a plurality of predetermined work conditions during the removal process, and
the plurality of work conditions are respectively associated with the plurality of portions of the substrate such that a processing liquid having a film-removal capability corresponding to each portion of the plurality of portions of the one surface of the substrate impinges on the portion.

2. The substrate processing apparatus according to claim 1, wherein
the first liquid supply system includes a first flow-rate adjuster that adjusts a flow rate of the first liquid flowing through the first pipe,
the second liquid supply system includes a plurality of second flow-rate adjusters that respectively adjust flow rates of the second liquid respectively flowing through the plurality of second pipes,
the plurality of work conditions include a plurality of target ratios associated with a flow rate of the second liquid flowing through each second pipe and a flow rate of the first liquid flowing through the first pipe, with the plurality of target ratios respectively corresponding to the plurality of portions of the one surface of the substrate, and
the controller controls the first flow-rate adjuster and the plurality of second flow-rate adjusters such that, for each portion of the substrate on which the processing liquid discharged from the nozzle is to impinge during the removal process, a ratio between a flow rate of the second liquid flowing through each second pipe and a flow rate of the first liquid flowing through the first pipe is the target ratio associated with the portion.

3. The substrate processing apparatus according to claim 1, wherein
the second liquid supply system further includes a plurality of open-close valves respectively provided in the plurality of second pipes,
the plurality of work conditions include open-close states of the plurality of open-close valves associated with each of the plurality of portions of the one surface of the substrate, and
the controller controls the plurality of open-close valves such that, for each portion of the substrate on which the processing liquid discharged from the nozzle is to impinge during the removal process, open-close states of the plurality of open-close valves correspond to the portion.

4. The substrate processing apparatus according to any one of claims 1 to 3, wherein
the nozzle includes a plurality of nozzles respectively corresponding to the plurality of portions of the one surface of the substrate,
the first liquid supply system includes a plurality of first liquid supply systems respectively corresponding to the plurality of nozzles,
the second liquid supply system includes a plurality of second liquid supply systems respectively corresponding to the plurality of nozzles, and
the substrate processing apparatus further includes a nozzle supporter that supports the plurality of nozzles such that discharge ports of the plurality of nozzles through which the processing liquid is discharged are respectively opposite to the plurality of portions of the one surface of the substrate.

5. The substrate processing apparatus according to any one of claims 1 to 3, further comprising a nozzle mover that supports the nozzle at a position above the substrate, and relatively moves the nozzle and the substrate with respect to each other in a horizontal plane, and
the controller controls the nozzle mover such that the processing liquid discharged from the nozzle sequentially impinges on the plurality of portions of the one surface of the substrate during the removal process.

6. A substrate processing method executed using a substrate processing apparatus, the substrate processing apparatus executing a removal process of removing, using a processing liquid including Caro's acid, an unnecessary film formed on one surface of a substrate, wherein
in a case in which one of sulfuric acid and a hydrogen peroxide solution is a first liquid, and another one of the sulfuric acid and the hydrogen peroxide solution is a second liquid, the Caro's acid is generated by mixing the first liquid and the second liquid,
the substrate processing apparatus includes
a nozzle that discharges the processing liquid such that the processing liquid impinges on a plurality of portions on the one surface of the substrate,
a first liquid supply system that includes a first pipe connected to the nozzle, and supplies the first liquid to the nozzle through the first pipe, and
a second liquid supply system that includes a plurality of second pipes respectively connected to a plurality of different portions of a liquid flow path formed by the nozzle and the first pipe, and supplies the second liquid into the first pipe through any one of the plurality of second pipes, and
the substrate processing method includes the steps of,
in regard to each portion of the plurality of portions of the one surface of the substrate, acquiring information relating to a film-removal capability of the processing liquid to be supplied to the portion,
based on the acquired information, setting work conditions of the first liquid supply system and the second liquid supply system corresponding to each of the plurality of portions of the substrate such that processing liquids having respectively corresponding film-removal capabilities impinge on the plurality of portions of the one surface of the substrate, and
controlling the first liquid supply system and the second liquid supply system based on the set work conditions of the first liquid supply system and the second liquid supply system.

7. The substrate processing method according to claim 6, wherein
the plurality of work conditions include a plurality of target ratios associated with a flow rate of the second liquid flowing through each second pipe and a flow rate of the first liquid flowing through the first pipe, with the plurality of target ratios respectively corresponding to the plurality of portions of the one surface of the substrate, and
the step of controlling the first liquid supply system and the second liquid supply system includes adjusting a flow rate of the first liquid flowing through the first pipe and respectively adjusting flow rates of the second liquid respectively flowing through the plurality of second pipes such that, for each portion of the substrate on which the processing liquid discharged from the nozzle is to impinge during the removal process, a ratio between a flow rate of the second liquid flowing through each second pipe and the flow rate of the first liquid flowing through the first pipe is the target ratio associated with the portion.

8. The substrate processing method according to claim 6, wherein
the second liquid supply system further includes a plurality of open-close valves respectively provided in the plurality of second pipes,
the plurality of work conditions include open-close states of the plurality of open-close valves associated with each of the plurality of portions of the one surface of the substrate, and
the step of controlling the first liquid supply system and the second liquid supply system includes controlling the plurality of open-close valves such that, for each portion of the substrate on which the processing liquid discharged from the nozzle is to during the removal process, open-close states of the plurality of open-close valves correspond to the portion.

9. The substrate processing method according to any one of claims 6 to 8, wherein
the nozzle includes a plurality of nozzles respectively corresponding to the plurality of portions of the one surface of the substrate,
the first liquid supply system includes a plurality of first liquid supply systems respectively corresponding to the plurality of nozzles,
the second liquid supply system includes a plurality of second liquid supply systems respectively corresponding to the plurality of nozzles, and
the substrate processing method includes the step of supporting the plurality of nozzles such that discharge ports of the plurality of nozzles through which the processing liquid is discharged are respectively opposite to the plurality of portions of the one surface of the substrate.

10. The substrate processing method according to any one of claims 6 to 8, further including the step of supporting the nozzle at a position above the substrate and relatively moving the nozzle and the substrate with respect to each other in a horizontal plane such that the processing liquid discharged from the nozzle sequentially impinges on the plurality of portions of the one surface of the substrate during the removal process.
